# EUROPEAN PATENT APPLICATION

(11) **EP 4 827 279 A1**
(43) Date of publication of application: **21.10.2026**
(21) Application number: 24903336.6
(22) Date of filing: 18.10.2024
(51) Int. Cl.: H10F 39/18, H04N 25/70

(54) **OPTICAL DETECTION DEVICE**

(30) Priority: 15.12.2023 JP 2023212393
(71) Applicant: Sony Semiconductor Solutions Corporation, Atsugi-shi, Kanagawa 243-0014 (JP)
(72) Inventor: ETOU, Shinichirou, Atsugi-shi, Kanagawa 243-0014 (JP); SAKANASHI, Kohei, Atsugi-shi, Kanagawa 243-0014 (JP)
(74) Representative: Müller Hoffmann & Partner
(86) International application number: PCT/JP2024/037252
(87) International publication number: WO 2025/126673

(57) **Abstract**

A light detecting device of the present disclosure includes: a first substrate including a photoelectric conversion element and a readout circuit, in which the photoelectric conversion element photoelectrically converts light, and the readout circuit is configured to output a signal based on electric charge photoelectrically converted in the photoelectric conversion element; a second substrate stacked with the first substrate and including a signal processor, in which the signal processor is configured to perform signal processing on the signal outputted from the readout circuit; and at least one transistor provided between the readout circuit and the signal processor. The first substrate includes a first semiconductor layer and a first wiring layer. The second substrate includes a second semiconductor layer and a second wiring layer. The transistor is provided in at least any one of the first wiring layer and the second wiring layer.

## Description

### Technical Field

The present disclosure relates to a light detecting device.

### Background Art

For imaging devices, there is technology to divide a signal line that reads out pixel signals into a plurality and thereby reduce a load on the signal line (see Patent Literature 1). Moreover, as a configuration of an imaging device, some imaging devices include a pixel substrate on which pixels are provided and a circuit substrate on which a signal processing circuit that processes pixel signals.

### Citation List

### Patent Literature

Patent Literature 1: International Patent Application Publication WO 2021/085025 A1

### Summary of Invention

The technology described in Patent Literature 1 provides a configuration in which signals outputted to the divided signal lines are synthesized by a synthetic circuit provided on side on which the circuit substrate is provided. This causes redundancy of wirings between the pixel substrate and the circuit substrate, and in the circuit substrate. Moreover, the circuit substrate ends up with a region in which the synthetic circuit is provided. This causes a deterrent to downsizing and speeding up of signal readout.

Thus, it is desirable to provide a light detecting device that makes it possible to reduce redundancy of wirings, leading to downsizing and speeding up of signal readout.

A light detecting device according to an embodiment of the present disclosure includes: a first substrate including a photoelectric conversion element and a readout circuit, the photoelectric conversion element photoelectrically converting light, and the readout circuit being configured to output a signal based on electric charge photoelectrically converted in the photoelectric conversion element; a second substrate stacked with the first substrate and including a signal processor, the signal processor being configured to perform signal processing on the signal outputted from the readout circuit; and at least one transistor provided between the readout circuit and the signal processor. The first substrate includes a first semiconductor layer and a first wiring layer, and the second substrate includes a second semiconductor layer and a second wiring layer. The transistor is provided in at least any one of the first wiring layer and the second wiring layer.

In the light detecting device according to the embodiment of the present disclosure, the at least one transistor is provided between the readout circuit in the first substrate and the signal processor in the second substrate. The transistor is provided in at least any one of the first wiring layer of the first substrate and the second wiring layer of the second substrate.

### Brief Description of Drawings

[FIG. 1] FIG. 1 is a block diagram illustrating an outline of an imaging device as a light detecting device according to a comparative example.
[FIG. 2] FIG. 2 is a configuration diagram illustrating an example of a pixel unit in an imaging device according to a light detecting device according to an embodiment of the present disclosure.
[FIG. 3] FIG. 3 is a configuration diagram illustrating an example of the pixel unit in the imaging device according to the embodiment.
[FIG. 4] FIG. 4 is a configuration diagram illustrating an outline of the imaging device according to the embodiment.
[FIG. 5] FIG. 5 is a configuration diagram schematically illustrating a configuration example 1 of the imaging device according to the embodiment.
[FIG. 6] FIG. 6 is a configuration diagram schematically illustrating the configuration example 1 of the imaging device according to the embodiment.
[FIG. 7] FIG. 7 is a configuration diagram schematically illustrating a configuration example 2 of the imaging device according to the embodiment.
[FIG. 8] FIG. 8 is a configuration diagram schematically illustrating a configuration example 3 of the imaging device according to the embodiment.
[FIG. 9] FIG. 9 is a configuration diagram schematically illustrating the configuration example 3 of the imaging device according to the embodiment.
[FIG. 10] FIG. 10 is a configuration diagram schematically illustrating a configuration example 4 of the imaging device according to the embodiment.
[FIG. 11] FIG. 11 is a configuration diagram schematically illustrating a configuration example 5 of the imaging device according to the embodiment.
[FIG. 12] FIG. 12 is a cross-sectional view schematically illustrating the configuration example 5 of the imaging device according to the embodiment.
[FIG. 13] FIG. 13 is a configuration diagram schematically illustrating a configuration example 6 of the imaging device according to the embodiment.
[FIG. 14] FIG. 14 is a block diagram depicting an example of schematic configuration of a vehicle control system.
[FIG. 15] FIG. 15 is a diagram of assistance in explaining an example of installation positions of an outside-vehicle information detecting section and an imaging section.

### Modes for Carrying Out the Invention

In the following, some embodiments of the present disclosure are described in detail with reference to the drawings. It is to be noted that the description is given in the following order.
0. Comparative Example
1. One Embodiment
1.1. Outline
1.2. Configuration Examples
1.3. Effects
2. Applied Example to Mobile Body
3. Other Embodiments

### <0. Comparative Example>

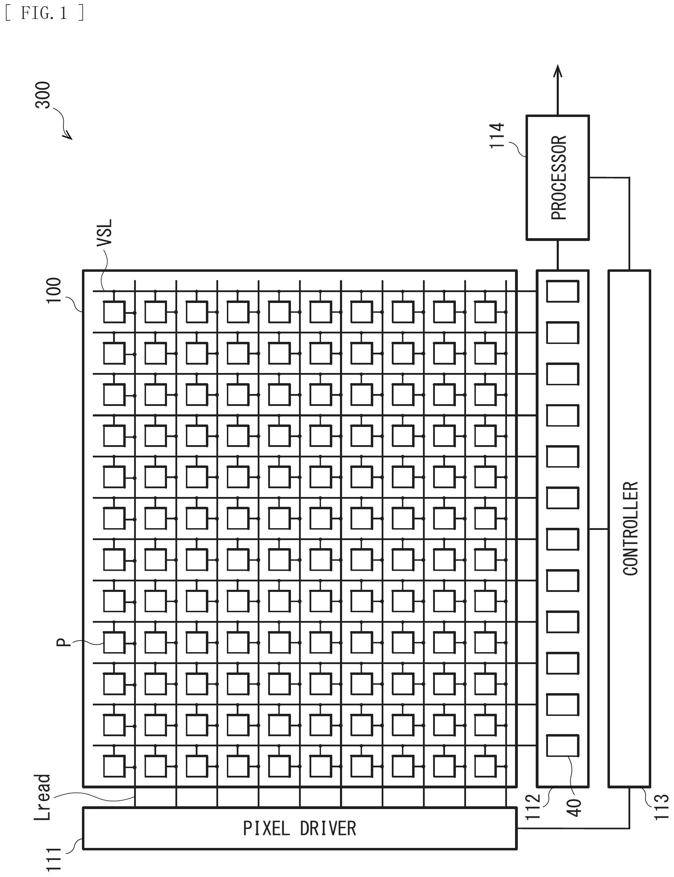

FIG. 1 is a block diagram illustrating an outline of an imaging device 300 as a light detecting device according to a comparative example.

Before describing a light detecting device according to one embodiment, described is a configuration example of an imaging device 300 as a light detecting device according to a comparative example. The light detecting device is a device configured to detect entering light. The imaging device 300 according to the comparative example includes a plurality of pixels P each including a photoelectric converter (photoelectric conversion element), and is configured to photoelectrically convert entering light to generate a signal. The imaging device 300 may receive light that has passed through an optical system (unillustrated) including an optical lens, to generate the signal.

The imaging device 300 includes, for example, a semiconductor substrate (for example, a silicon substrate) provided with the plurality of the pixels P. The photoelectric converter of each pixel P of the imaging device 300 is, for example, a photodiode (PD), and is configured to photoelectrically convert light. The imaging device 300 includes, as an imaging area, a region (pixel unit 100) in which the plurality of the pixels P is two-dimensionally arrayed in a matrix. The pixel unit 100 is a pixel array in which the plurality of the pixels P is disposed, and may be referred to as a light receiving region.

The imaging device 300 takes in entering light (image light) from a subject through the optical system including the optical lens. The imaging device 300 captures an image of the subject formed by the optical lens. The imaging device 300 may photoelectrically convert the received light to generate a pixel signal. The imaging device 300 is, for example, a CMOS (Complementary Metal Oxide Semiconductor) image sensor. The imaging device 300 may be used in, for example, electronic devices such as a digital still camera, a video camera, and a mobile phone.

The imaging device 300 includes, for example, a pixel driver 111, a signal processor 112, a controller 113, a processor 114, and the like in a peripheral region of the pixel unit 100 (pixel array). Moreover, the imaging device 300 is provided with a plurality of control lines Lread and a plurality of signal lines VSL.

The control line Lread is a signal line configured to transmit a signal that controls the pixel P, and is coupled to the pixel driver 111 and the pixel P of the pixel unit 100. In the example illustrated in FIG. 1, in the pixel unit 100, the plurality of the control lines Lread is wired for respective pixel rows each including the plurality of the pixels P disposed side by side in a horizontal direction (row direction). The control line Lread is configured to transmit a control signal for signal readout from the pixel P.

The plurality of the control lines Lread for the respective pixel rows of the imaging device 300 includes, for example, a wiring that transmits a signal that controls a transfer transistor, a wiring that transmits a signal that controls a selector transistor, a wiring that transmits a signal that controls a reset transistor, and the like. The control line Lread may be referred to as a driver line (pixel driver line) that transmits a signal that drives the pixel P.

The signal line VSL is a signal line configured to transmit the signal from the pixel P, and is coupled to the pixel P of the pixel unit 100 and the signal processor 112. To the pixel unit 100, for example, the one or more signal lines VSL are wired for each pixel column including the plurality of the pixels P disposed side by side in a vertical direction (column direction).

The signal line VSL is a vertical signal line, and is configured to transmit the signal outputted from the pixel P. In the imaging device 300, the plurality of the signal lines VSL may be provided for one pixel column. The imaging device 300 may include the plurality of the signal lines VSL for each pixel column.

The pixel driver 111 is configured to drive each pixel P of the pixel unit 100. The pixel driver 111 is a driver circuit, and includes a plurality of circuits including, for example, a buffer, a shift register, an address decoder, and the like. The pixel driver 111 (pixel driver circuit) generates the signal to drive the pixel P, and outputs the signal to each pixel P of the pixel unit 100 through the control line Lread. The pixel driver 111 is controlled by the controller 113 and controls the pixel P of the pixel unit 100.

For example, the pixel driver 111 generates the signals to control the pixel P, e.g., the signal that controls the transfer transistor of the pixel P, the signal that controls the selector transistor, the signal that controls the reset transistor, and the like, and supplies the generated signals to each pixel P through the control line Lread. The pixel driver 111 may make a control to read out the pixel signal from each pixel P. The pixel driver 111 may be referred to as a pixel controller configured to control each pixel P. It is to be noted that the pixel driver 111 and the controller 113 may also be collectively referred to as a pixel controller.

The signal processor 112 is configured to perform signal processing on the inputted signal of the pixel P. The signal processor 112 is a signal processing circuit, and includes, for example, a load circuit unit, an AD converter 40, and a horizontal selector switch, and the like. The load circuit unit includes, for example, a current source configured to supply a current to an amplifier transistor of the pixel P. The load circuit unit constitutes, for example, a source follower circuit together with the amplifier transistor of the pixel P. It is to be noted that the signal processor 112 may include an amplifier circuit unit configured to amplify the signal to be read out from the pixel P through the signal line VSL.

The signal processor 112 may include a plurality of the AD converters 40 (AD converter circuits), and output the pixel signals converted into digital signals by the AD converters 40. The AD converters 40 are ADCs (Analog to Digital Converters). The AD converters 40 are provided for respective ones of the plurality of the signal lines VSL, for example. The AD converters 40 may be provided for respective pixel columns of the pixel unit 100. The AD converters 40 are not limited to SS (single-slope) ADCs, but may be ADCs of other configurations.

The AD converters 40 are each configured to convert an inputted analog signal into a digital signal. The AD converters 40 each perform AD conversion processing on the signal of the pixel P as the analog signal inputted from each pixel P through the signal line VSL. The AD converters 40 (AD conversion circuits) each include, for example, a comparator circuit (comparator circuit) and a counter, and may convert the inputted signal of the pixel P into the digital signal of the predetermined number of bits.

The signal outputted from each pixel P selected and scanned by the pixel driver 111 is inputted to the signal processor 112 through the signal line VSL. The signal processor 112 may perform, for example, the signal processing such as AD conversion of the signal of the pixel P and CDS (Correlated Double Sampling: correlated double sampling). The signal of each pixel P transmitted through each of the signal lines VSL is subjected to the signal processing by the signal processor 112, and is outputted to the processor 114.

The processor 114 is configured to perform signal processing on a signal inputted. The processor 114 is a processing circuit, and includes, for example, a circuit that performs various kinds of signal processing on the pixel signal. The processor 114 may include a processor and a memory. The processor 114 performs the signal processing on the signal of the pixel P inputted from the signal processor 112, and outputs the processed signal of the pixel P. The processor 114 may perform various kinds of the signal processing such as noise reduction processing and gradation correction processing.

The controller 113 is configured to control each unit of the imaging device 300. The controller 113 may receive a clock supplied from outside, data that commands an operation mode, and the like, and may output data such as internal information regarding the imaging device 300. The controller 113 is a control circuit, and includes, for example, a timing generator configured to generate various timing signals.

The controller 113 performs a driving control of the pixel driver 111, the signal processor 112, and the like based on the various timing signals (pulse signals, clock signals, and the like) generated by the timing generator. It is to be noted that some or all of the signal processor 112, the controller 113, and the processor 114 may be unitized.

### <1. One Embodiment>

Next, a detection device according to one embodiment of the present disclosure is described. It is to be noted that, in the following, the substantially same parts as the constituent elements of the imaging device 300 as the detection device according to the comparative example are denoted by the same reference numerals, and description thereof is omitted as appropriate.

### <1.1. Outline>

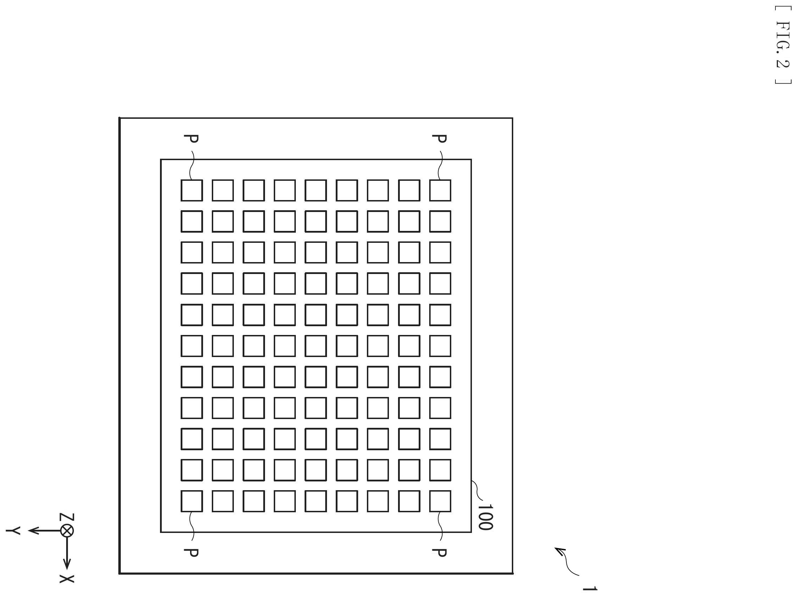

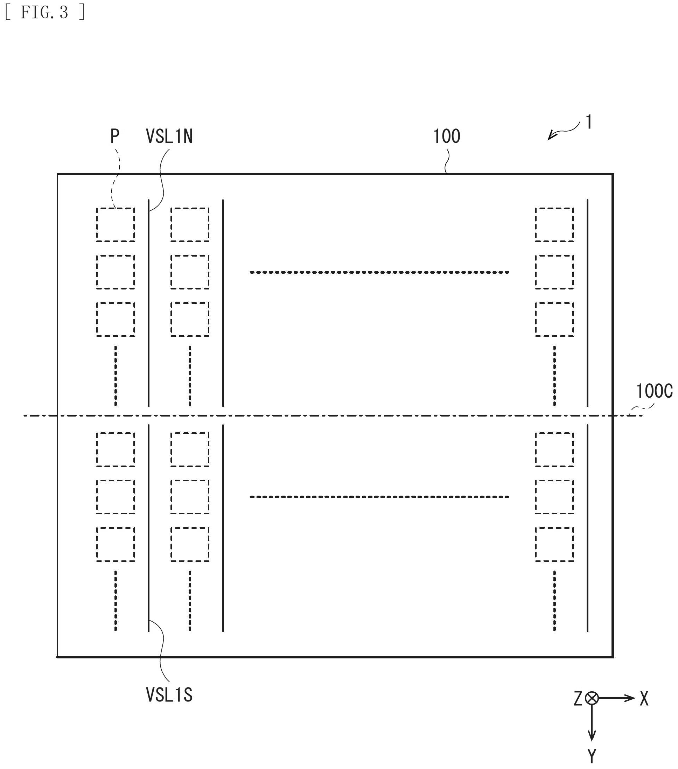

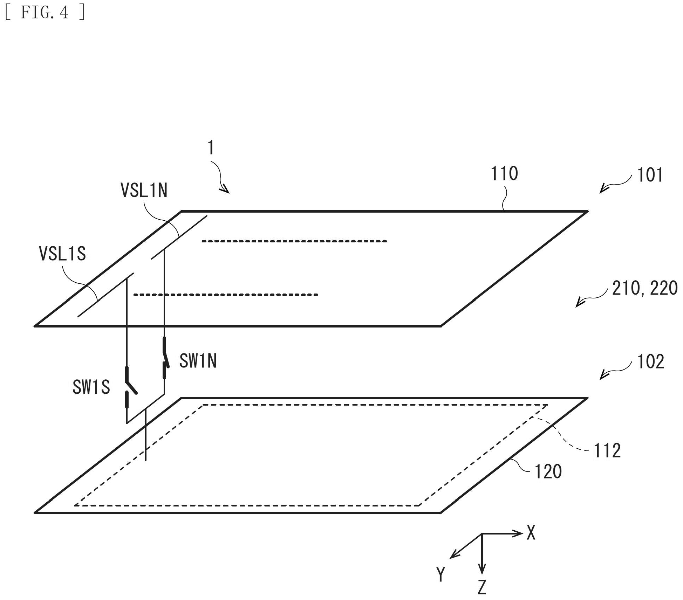

FIG. 2 is a configuration diagram illustrating an example of the pixel unit 100 in the imaging device 1 as the detection device according to the embodiment of the present disclosure. FIG. 3 is a configuration diagram illustrating an example of the pixel unit 100 in the imaging device 1 according to the embodiment. FIG. 4 is a configuration diagram illustrating an outline of the imaging device 1 according to the embodiment.

In the following, as illustrated in FIG. 2, a direction of entry of the light from the subject is assumed to be a Z-axis direction. A horizontal direction along the paper surface orthogonal to the Z-axis direction is assumed to be an X-axis direction. A vertical direction along the paper surface orthogonal to the Z-axis direction and the X-axis direction is assumed to be a Y-axis direction.

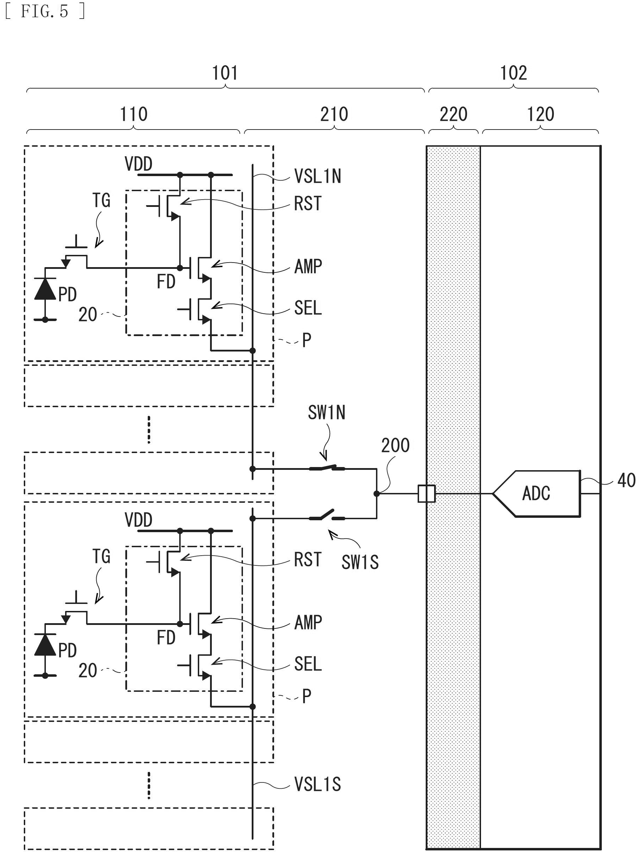

As illustrated in FIGs. 3 and 4, the imaging device 1 according to the embodiment includes, as the signal lines VSL, for example, a first divided signal line VSL1N and a second divided signal line VSL1S that are divided in the central portion 100C of the pixel unit 100. To the first divided signal line VSL1N, a signal from a readout circuit 20 (see FIG. 5, etc. described later) in at least one first pixel out of the plurality of the pixels P is outputted. To the second divided signal line VSL1S, a signal from the readout circuit 20 in at least one second pixel out of the plurality of the pixels P is outputted.

As illustrated in FIG. 4, the imaging device 1 according to the embodiment includes a first substrate 101 and a second substrate 102 stacked with the first substrate 101. The first substrate 101 includes a first semiconductor layer 110 and a first wiring layer 210. The second substrate 102 includes a second semiconductor layer 120 and a second wiring layer 220.

The first semiconductor layer 110 of the first substrate 101 includes a photodiode PD as a photoelectric conversion element and the readout circuit 20 configured to output a signal based on electric charge converted by the photodiode PD. The first semiconductor layer 110 includes the plurality of the pixels P each including the photodiode PD and the readout circuit 20.

The second semiconductor layer 120 of the second substrate 102 includes the signal processor 112 configured to perform the signal processing on the signal outputted from the readout circuit 20.

The imaging device 1 according to the embodiment includes at least one transistor provided between the readout circuit 20 and the signal processor 112. The at least one transistor is provided in at least any one of the first wiring layer 210 and the second wiring layer 220.

The at least one transistor is, for example, a switching transistor configured to switch an electrical coupling state between the readout circuit 20 and the signal processor 112. The transistor is, for example, a switching transistor configured to switch an electrical coupling state between the signal line VSL and the signal processor 112.

As the switching transistor, the imaging device 1 according to the embodiment may include, for example, as illustrated in FIG. 4, a first switching transistor (first switching switch SW1N) and a second switching transistor (second switching switch SW1S).

The first switching transistor (first switching switch SW1N) includes a first coupling end and a second coupling end. In the first switching switch SW1N, the first coupling end is coupled to the first divided signal line VSL1N, while the second coupling end is coupled to the signal processor 112. The first switching switch SW1N may be configured to switch an electrical coupling state between the first divided signal line VSL1N and the signal processor 112.

The second switching transistor (second switching switch SW1S) includes a first coupling end and a second coupling end. In the second switching switch SW1S, the first coupling end is coupled to the second divided signal line VSL1S, while the second coupling end is coupled to the signal processor 112. The second switching switch SW1S may be configured to switch an electrical coupling state between the second divided signal line VSL1S and the signal processor 112.

### <2. Configuration Examples>

In the following, more detailed configuration examples of the imaging device 1 according to the embodiment are described.

### <Configuration Example 1>

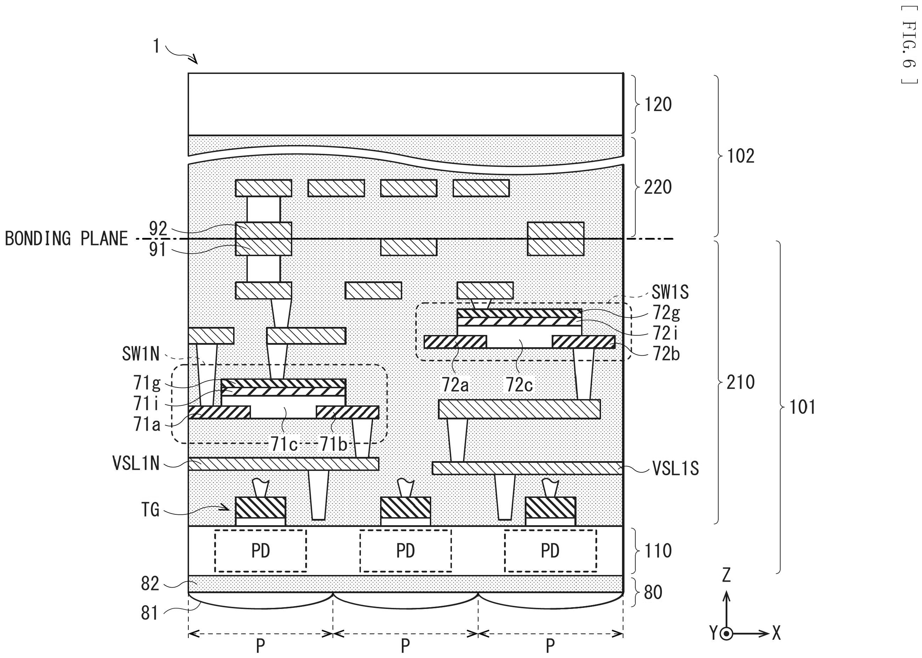

FIG. 5 is a configuration diagram schematically illustrating a configuration example 1 of the imaging device 1 according to the embodiment. FIG. 6 is a cross-sectional view schematically illustrating the configuration example 1 of the imaging device 1 according to the embodiment.

For example, as illustrated in FIG. 6, the imaging device 1 includes a lightguide 80, the first substrate 101 and the second substrate 102. The first substrate 101 includes the first semiconductor layer 110 and the first wiring layer 210. The second substrate 102 includes the second semiconductor layer 120 and the second wiring layer 220.

The imaging device 1 has a configuration in which the lightguide 80, the first semiconductor layer 110, the first wiring layer 210, the second wiring layer 220, and the second semiconductor layer 120 are stacked in the Z-axis direction. The lightguide 80, the first semiconductor layer 110, the first wiring layer 210, the second wiring layer 220, and the second semiconductor layer 120 are provided from light entering side. The first semiconductor layer 110 and the second semiconductor layer 120 each include a semiconductor substrate (for example, a silicon substrate, an SOI substrate, or the like).

The lightguide 80 includes a lens 81 and a filter 82, and guides the entering light toward the first semiconductor layer 110. The photodiode PD photoelectrically converts the light that enters through the lens 81 and the filter 82.

The lens 81 is provided, for example, for each pixel P or in units of the plurality of the pixels P. The lens 81 is an optical member also called an on-chip lens. The light from the subject enters the lens 81 through an optical system such as an imaging lens.

The filter 82 is configured to selectively transmit the light in a specific wavelength range within the entering light. The filter 82 is an RGB color filter, a complementary color filter, a filter that transmits the infrared light, or the like, and is provided between the lens 81 and the first semiconducting layer 110. It is to be noted that the filter 82 may be omitted as needed. Moreover, some or all of the pixels P of the imaging device 1 may be devoid of the filter 82. For example, the pixel P that receives the white (W) light and performs photoelectric conversion may be devoid of the filter 82.

The first wiring layer 210 includes a plurality of electrodes 91 while the second wiring layer 220 includes a plurality of electrodes 92. The electrodes 91 and the electrodes 92 are each an electrode including, for example, copper (Cu). The electrodes 91 and the electrodes 92 are electrodes to be used for bonding between metal electrodes, and may be referred to as bonding electrodes. For example, the first substrate 101 and the second substrate 102 are bonded together by bonding between metal electrodes (the electrodes 91 and the electrodes 92) including Cu, that is, Cu-Cu bonding.

By the electrodes 91 and the electrodes 92, the circuits of the first substrate 101 and the circuits of the second substrate 102 are electrically coupled. In the second semiconductor layer 120, for example, the signal processor 112 including the AD converters 40 is provided. Moreover, in the second semiconductor layer 120, the pixel driver 111, the controller 113, the processor 114, and the like may be provided. In the second semiconductor layer 120, other circuits such as a memory, a processor, a power supply circuit, and an interface circuit may be provided.

It is to be noted that the electrodes 91 and the electrodes 92 may include a metal material other than copper, for example, nickel (Ni), cobalt (Co), gold (Au), or the like. Alternatively, the first substrate 101 and the second substrate 102 may be stacked using bumps.

As illustrated in FIG. 5, the pixel P of the imaging device 1 includes the photodiode PD, a transfer transistor TG, a floating diffusion FD, and the readout circuit 20. The photodiode PD is configured to receive light and generate a signal. The photodiode PD is configured to generate the electric charge by the photoelectric conversion.

The readout circuit 20 is configured to output the signal based on the electric charge photoelectrically converted.

The transfer transistor TG is configured to transfer the electric charge photoelectrically converted by the photodiode PD to the floating diffusion FD. The transfer transistor TG electrically couples or disconnects the photodiode PD to or from the floating diffusion FD. The transfer transistor TG may transfer the electrical charge photoelectrically converted and accumulated by the photodiode PD to the floating diffusion FD.

The floating diffusion FD is an accumulator and is configured to accumulate the transferred electrical charge. The floating diffusion FD may accumulate the electrical charge photoelectrically converted by the photodiode PD. The floating diffusion FD may be also referred to as a retainer configured to hold the transferred electrical charge. The floating diffusion FD accumulates the transferred electrical charge and converts the electrical charge into a voltage corresponding to a capacity of the floating diffusion FD.

For example, as illustrated in FIG. 5, the readout circuit 20 includes an amplifier transistor AMP, a selector transistor SEL, and a reset transistor RST. The amplifier transistor AMP is configured to generate and output the signal based on the electrical charge accumulated in the floating diffusion FD. A gate of the amplifier transistor AMP is electrically coupled to the floating diffusion FD and is supplied with the voltage converted by the floating diffusion FD.

A drain of the amplifier transistor AMP is coupled to a power supply line to which a power supply voltage VDD is supplied. A source of the amplifier transistor AMP is coupled to the signal line VSL through the selector transistor SEL. The amplifier transistor AMP may generate the signal based on the electrical charge accumulated in the floating diffusion FD, that is, a signal based on the voltage of the floating diffusion FD, and may output the signal to the signal line VSL. The amplifier transistor AMP is configured to generate the signal based on the electrical charge converted by the photodiode PD.

The selector transistor SEL is configured to control an output of the signal of the pixel P. The selector transistor SEL is configured to output the signal from the amplifier transistor AMP to the signal line VSL. The selector transistor SEL may control output timing of the signal of the pixel P. The selector transistor SEL is configured to output the signal based on the electrical charge converted by the photodiode PD. It is to be noted that the selector transistor SEL may be provided between the power supply line to which the power supply voltage VDD is applied and the amplifier transistor AMP. Moreover, the selector transistor SEL may be omitted as needed.

The reset transistor RST is configured to reset the voltage of the floating diffusion FD. The reset transistor RST is electrically coupled to the power supply line to which the power supply voltage VDD is applied, and is configured to reset the electrical charge of the pixel P. The reset transistor RST may reset the electrical charge accumulated in the floating diffusion FD and reset the voltage of the floating diffusion FD.

The transfer transistor TG, the amplifier transistor AMP, the selector transistor SEL, and the reset transistor RST may each be a MOS transistor (MOSFET) including gate, source, and drain terminals. In the configuration example in FIG. 5, the transfer transistor TG, the amplifier transistor AMP, the selector transistor SEL, and the reset transistor RST each include an NMOS transistor. It is to be noted that the transfer transistor TG, the amplifier transistor AMP, the selector transistor SEL, and the reset transistor RST may include PMOS transistors.

The first semiconductor layer 110 and the second semiconductor layer 120 include a semiconductor substrate, for example, a Si (silicon) substrate. It is to be noted that the first semiconductor layer 110 and the second semiconductor layer 120 may include an SOI (Silicon On Insulator) substrate, a SiGe (silicon germanium) substrate, or other compound semiconductor materials, etc.

Insulating films (interlayer insulating films) of the first wiring layer 210 and the second wiring layer 220 include, for example, TEOS, silicon nitride (SiN), silicon oxide (SiO), or the like. Moreover, for example, the insulating film of the first wiring layer 210 may include SiCN, SiCON, HfO₂, Al₂O₃, ZrO₂, or the like. It is to be noted that the insulating films of the first wiring layer 210 and the second wiring layer 220 may include other insulating materials. The insulating films of the first wiring layer 210 and the second wiring layer 220 are also passivation films (protective films) of the thin film transistors, and are formed to cover the periphery of each thin film transistor.

The first wiring layer 210 and the second wiring layer 220 may be, for example, wiring layers formed by a BEOL (Back End of Line).

The first wiring layer 210 and the second wiring layer 220 include, for example, a conductive film and an insulating film, and include a plurality of wirings and vias (VIA), an interlayer insulating film, and the like. The wirings of the first wiring layer 210 and the second wiring layer 220 include, for example, a metal material such as aluminum (Al), copper (Cu), and tungsten (W). The wirings of the first wiring layer 210 may include other conductive materials. The interlayer insulating film includes, for example, silicon oxide (SiO), silicon nitride (SiN), silicon oxynitride (SiON), or the like.

In the imaging device 1 according to the configuration example 1, in the first wiring layer 210, the first switching transistor (first switching switch SW1N) and the second switching transistor (second switching switch SW1S) are provided. The first switching switch SW1N and the second switching switch SW1S may be thin film transistors (TFTs: Thin Film Transistors).

As illustrated in FIG. 5, the imaging device 1 according to the configuration example 1 further includes a coupling unit 200. The coupling unit 200 is provided in the first wiring layer 210. The coupling unit 200 is coupled to the second coupling end of the first switching switch SW1N and the second coupling end of the second switching switch SW1S. Thus, the second coupling end of the first switching switch SW1N and the second coupling end of the second switching switch SW1S are commonly coupled to the AD converter 40 of the signal processor 112 through the coupling unit 200.

As illustrated in FIG. 6, the first switching switch SW1N includes an electrode (drain electrode or source electrode) 71a, an electrode (source electrode or drain electrode) 71b, a semiconductor region 71c, a gate electrode 71g, and a gate insulator film 71i.

As illustrated in FIG. 6, the second switching switch SW1S includes an electrode (drain electrode or source electrode) 72a, an electrode (source electrode or drain electrode) 72b, a semiconductor region 72c, a gate electrode 72g, and a gate insulator film 72i.

The semiconductor region 71c and the semiconductor region 72c are each a region (channel region) in which a channel is formed. The semiconductor region 71c and the semiconductor region 72c each include, for example, a two-dimensional substance (such as MoS₂, WS₂, MoSe₂, WSe₂, or HfS₂) or an oxide semiconductor (such as InGaZnO, InZnO, ZnO, SnO, or TiO₂).

It is to be noted that the semiconductor region 71c and the semiconductor region 72c may each include an organic semiconductor (fullerene, pentacene, rubrene, or the like), carbon nanotubes, hydrogenated amorphous silicon, low-temperature polysilicon, or the like as a channel material.

The electrode 71a, the electrode 71b, the electrode 72a, and the electrode 72b each include a metal material such as copper (Cu), tungsten (W), ruthenium (Ru), or cobalt (Co). It is to be noted that the electrode 71a, the electrode 71b, the electrode 72a, and the electrode 72b may include other conductive materials. The electrode 71a, the electrode 71b, the electrode 72a, and the electrode 72b may include a low-resistance conductive material.

The gate insulator film 71i and the gate insulator film 72i each include, for example, silicon oxide (SiO), silicon nitride (SiN), or the like. Moreover, for example, the gate insulator film 71i and the gate insulator film 72i each include an insulating material such as Al₂O₃, HfO₂, ZrO₂, LaO₂, HfSiO, Y₂O₃, or SiON. It is to be noted that the gate insulator film 71i and the gate insulator film 72i may include other insulating materials.

The gate electrode 71g and the gate electrode 72g each include, for example, a metal material such as Au, Pt, Cu, Ti, W, Pd, TiN, TaN, TiAl, Bi, In, Al, Sc, Co, Mo, or the like. The gate electrode 71g and the gate electrode 72g may include other conductive materials.

It is to be noted that the configuration illustrated in FIG. 6 such as positions where the first switching transistor (the first switching switch SW1N) and the second switching transistor (the second switching switch SW1S) are disposed are an example, and other configurations may be adopted.

### <Configuration Example 2>

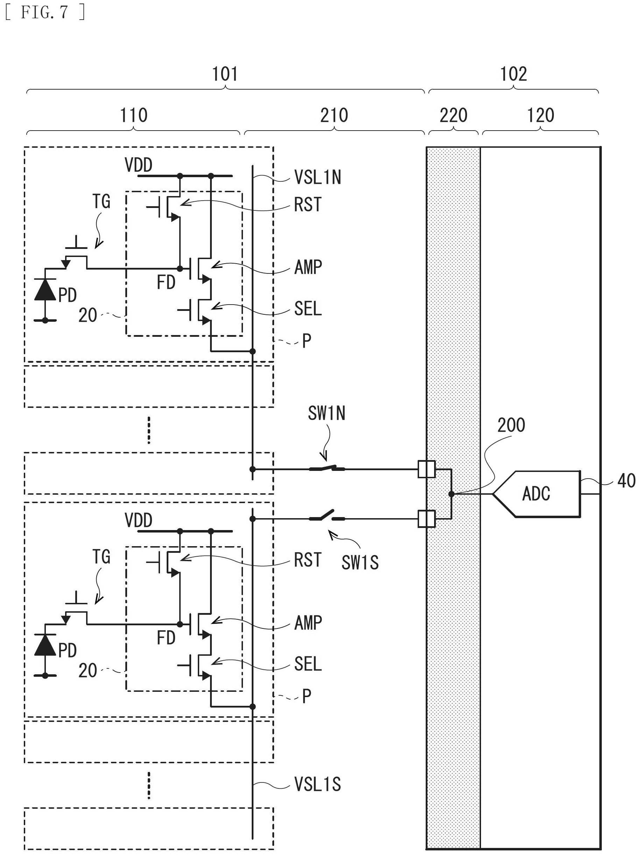

FIG. 7 is a configuration diagram schematically illustrating a configuration example 2 of the imaging device 1 according to the embodiment.

The imaging device 1 according to the configuration example 2 differs from the forgoing configuration example 1 in a position where the coupling unit 200 is disposed. In the imaging device 1 according to the configuration example 2, the coupling unit 200 is provided in the second wiring layer 220. That is, in the imaging device 1 according to the configuration example 2, the second coupling end of the first switching switch SW1N and the second coupling end of the second switching switch SW1S are coupled together in the second wiring layer 220. Thus, the second coupling end of the first switching switch SW1N and the second coupling end of the second switching switch SW1S are commonly coupled to the AD converter 40 of the signal processor 112 through the coupling unit 200.

Other configurations may be substantially similar to those of the configuration example 1.

### <Configuration Example 3>

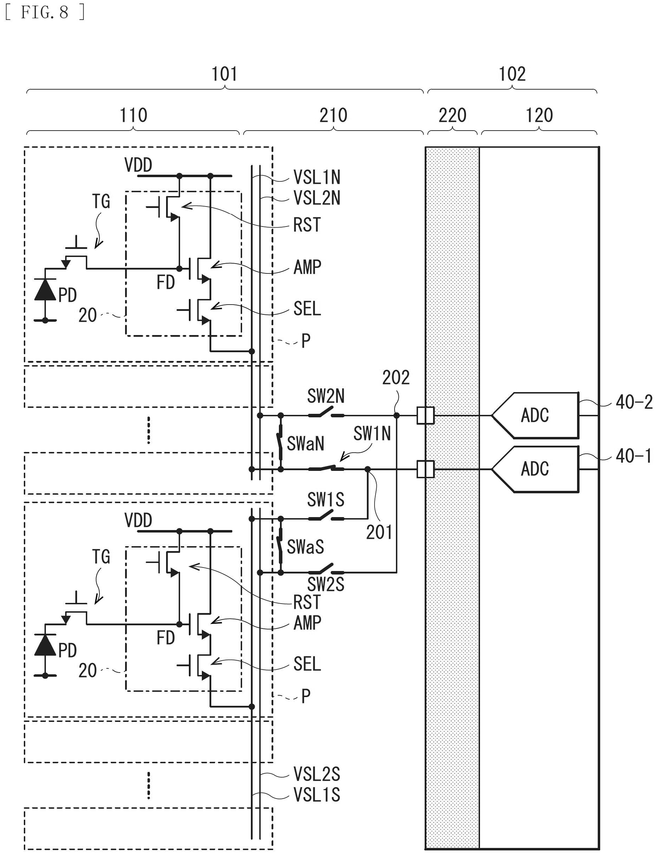

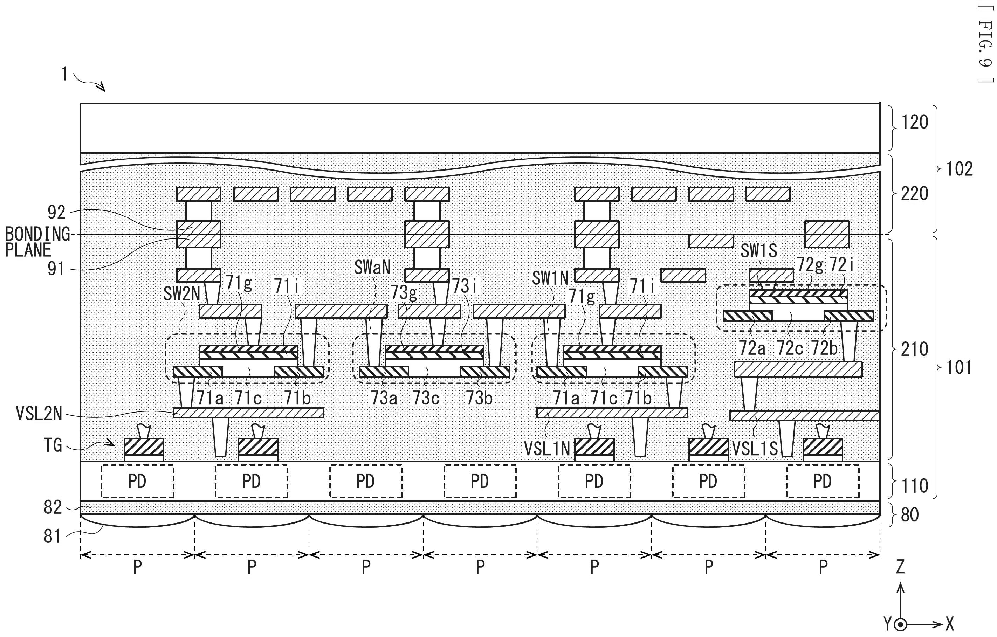

FIG. 8 is a configuration diagram schematically illustrating a configuration example 3 of the imaging device 1 according to the embodiment. FIG. 9 is a cross-sectional view schematically illustrating the configuration example 3 of the imaging device 1 according to the embodiment.

In addition to the configuration example 1, the imaging device 1 according to the configuration example 3 further includes a third divided signal line VSL2N and a fourth divided signal line VSL2S, as the signal lines VSL. The third divided signal line VSL2N is disposed in parallel with the first divided signal line VSL1N. The fourth divided signal line VSL2S is disposed in parallel with the second divided signal line VSL1S.

To the third divided signal line VSL2N, the signal from the readout circuit 20 in the at least one first pixel out of the plurality of the pixels P is outputted. To the fourth divided signal line VSL2S, the signal from the readout circuit 20 in the at least one second pixel out of the plurality of the pixels P is outputted.

Moreover, in addition to the configuration example 1, the imaging device 1 according to the configuration example 3 further includes a third switching transistor (third switching switch SW2N) and a fourth switching transistor (fourth switching switch SW2S) as the switching transistor.

The third switching switch SW2N includes a first coupling end and a second coupling end. The first coupling end of the third switching switch SW2N is coupled to the third divided signal line VSL2N. The second coupling end of the third switching switch SW2N is coupled to the signal processor 112. By the third switching switch SW2N, it is possible to switch an electrical coupling state between the third divided signal line VSL2N and the signal processor 112.

The fourth switching switch SW2S includes a first coupling end and a second coupling end. The first coupling end of the fourth switching switch SW2S is coupled to the fourth divided signal line VSL2S. The second coupling end of the fourth switching switch SW2S is coupled to the signal processor 112. By the fourth switching switch SW2S, it is possible to switch an electrical coupling state between the fourth divided signal line VSL2S and the signal processor 112.

Moreover, the imaging device 1 according to the configuration example 3 further includes a first adder transistor (first adder switch SWaN) and a second adder transistor (second adder switch SWaS).

The first adder switch SWaN is configured to switch an electrical coupling state between the first divided signal line VSL1N and the third divided signal line VSL2N, and to add up a plurality of signals from a plurality of the readout circuits 20 in a plurality of the first pixels.

The second adder switch SWaS is configured to switch an electrical coupling state between the second divided signal line VSL1S and the fourth divided signal line VSL2S, and to add up a plurality of signals from a plurality of the readout circuits 20 in a plurality of the second pixels.

Moreover, the imaging device 1 according to the configuration example 3 includes a first coupling unit 201 and a second coupling unit 202 in place of the coupling unit 200 in the configuration example 1.

The first coupling unit 201 is provided in the first wiring layer 210. The first coupling unit 201 is coupled to the second coupling end of the first switching switch SW1N and the second coupling end of the second switching switch SW1S.

The second coupling unit 202 is provided in the first wiring layer 210. The second coupling unit 202 is coupled to the second coupling end of the third switching switch SW2N and the second coupling end of the fourth switching switch SW2S.

In the imaging device 1 according to the configuration example 3, the second coupling end of the first switching switch SW1N and the second coupling end of the second switching switch SW1S are commonly coupled to an AD converter 40-1 of the signal processor 112 through the first coupling unit 201.

Moreover, the second coupling end of the third switching switch SW2N and the second coupling end of the fourth switching switch SW2S are commonly coupled to an AD converter 40-2 of the signal processor 112 through the second coupling unit 202.

It is to be noted that FIG. 8 illustrates a configuration example in which the first switching switch SW1N, the third switching switch SW2N, the first adder switch SWaN, the second switching switch SW1S, the fourth switching switch SW2S, the second adder switch SWaS, the first coupling unit 201, and the second coupling unit 202 are all provided in the first wiring layer 210, but some or all of them may be provided in the second wiring layer 220.

As illustrated in FIG. 9, as with the first switching switch SW1N, the third switching switch SW2N may include the electrode (drain electrode or source electrode) 71a, the electrode (source electrode or drain electrode) 71b, the semiconductor region 71c, the gate electrode 71g, and the gate insulator film 71i.

As with the second switching switch SW1S, the fourth switching switch SW2S may include the electrode (drain electrode or source electrode) 72a, the electrode (source electrode or drain electrode) 72b, the semiconductor region 72c, the gate electrode 72g, and the gate insulator film 72i.

As illustrated in FIG. 9, the first adder switch SWaN and the second adder switch SWaS may include an electrode (drain electrode or source electrode) 73a, an electrode (source electrode or drain electrode) 73b, a semiconductor region 73c, a gate electrode 73g, and a gate insulating film 73i.

In the imaging device 1 according to the configuration example 3, by the first adder switch SWaN, it is possible to provide operation of adding a signal from the first divided signal line VSL1N and a signal from the third divided signal line VSL2N.

Moreover, by the second adder switch SWaS, it is possible to provide operation of adding a signal from the second divided signal line VSL1S and a signal from the fourth divided signal line VSL2S.

Other configurations may be substantially similar to those of the forgoing configuration example 1.

### <Configuration Example 4>

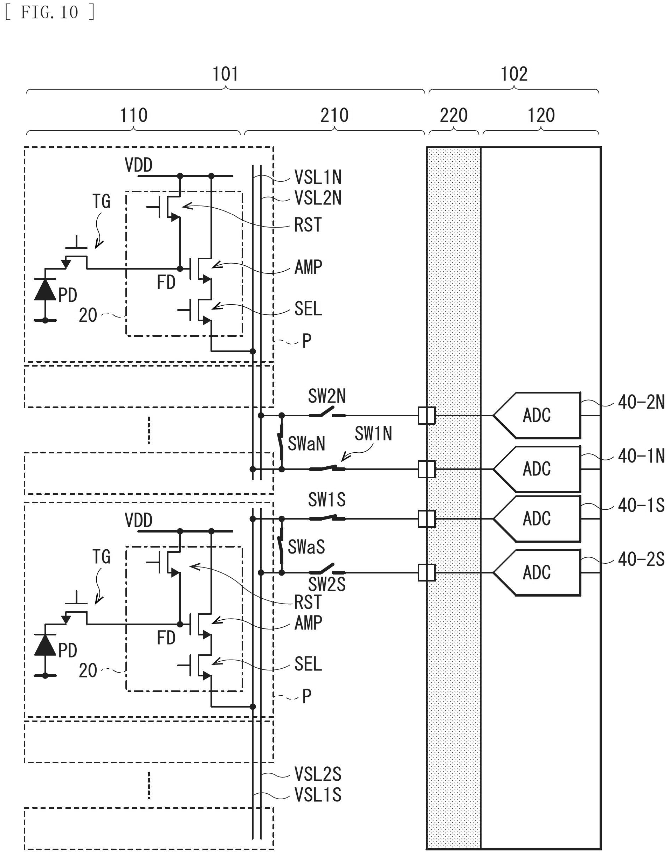

FIG. 10 is a configuration diagram schematically illustrating a configuration example 4 of the imaging device 1 according to the embodiment.

The imaging device 1 according to the configuration example 4 has a configuration where the first coupling unit 201 and the second coupling unit 202 are omitted from the configuration example 3.

In the imaging device 1 according to the configuration example 4, the second coupling end of the first switching switch SW1N is coupled to an AD converter 40-1N of the signal processor 112.

Moreover, the second coupling end of the second switching switch SW1S is coupled to an AD converter 40-1S of the signal processor 112.

Furthermore, the second coupling end of the third switching switch SW2N is coupled to an AD converter 40-2N of the signal processor 112.

In addition, the second coupling end of the fourth switching switch SW2S is coupled to an AD converter 40-2S of the signal processor 112.

Other configurations may be substantially similar to as those of the forgoing configuration example 3.

### <Configuration Example 5>

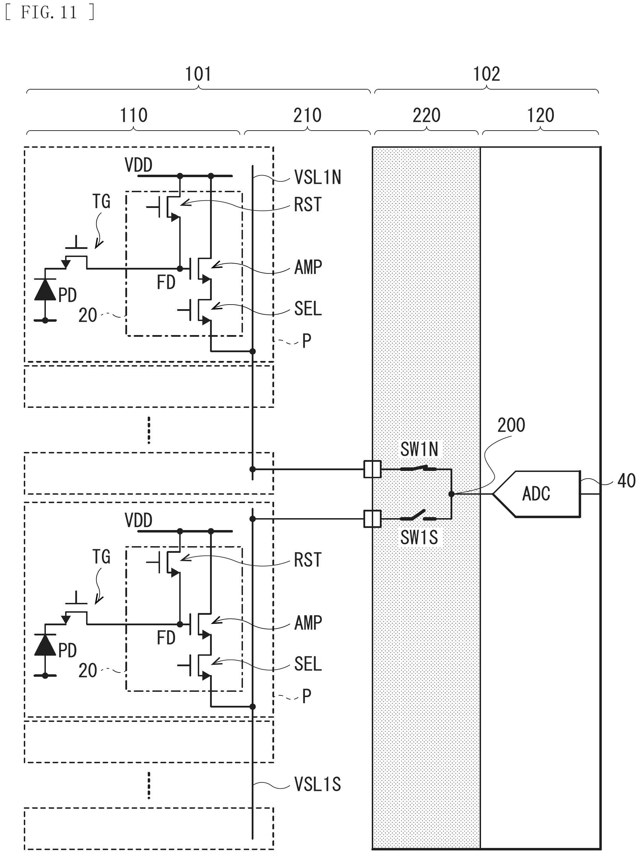

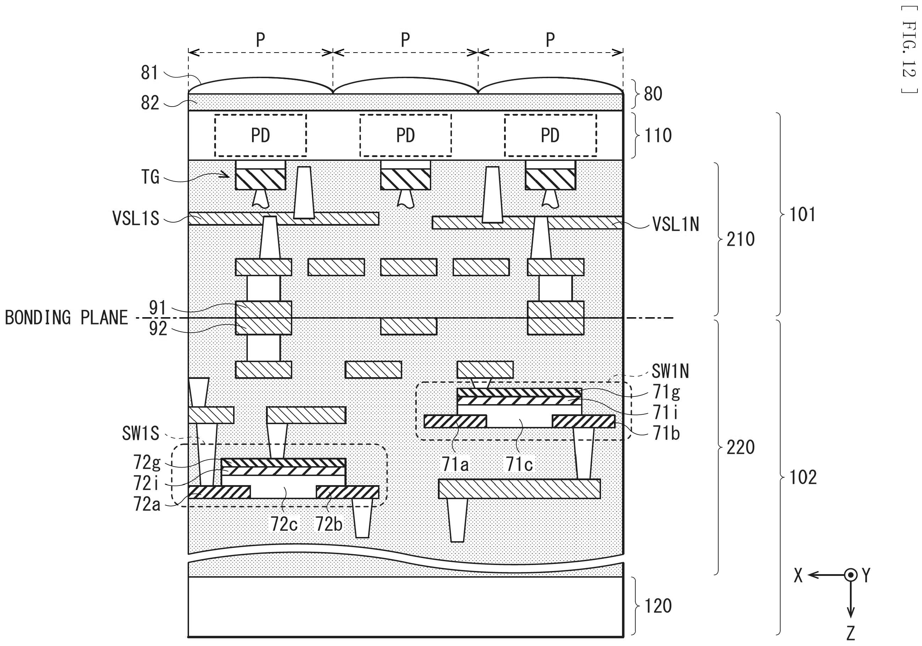

FIG. 11 is a configuration diagram schematically illustrating a configuration example 5 of the imaging device 1 according to the embodiment. FIG. 12 is a cross-sectional view schematically illustrating the configuration example 5 of the imaging device 1 according to the embodiment.

The imaging device 1 according to the configuration example 5 has a configuration in which, unlike the forgoing configuration example 1, the first switching switch SW1N, the second switching switch SW1S, and the coupling unit 200 are all provided in the second wiring layer 220.

Other configurations may be substantially similar to those of the forgoing configuration example 1.

### <Configuration Example 6>

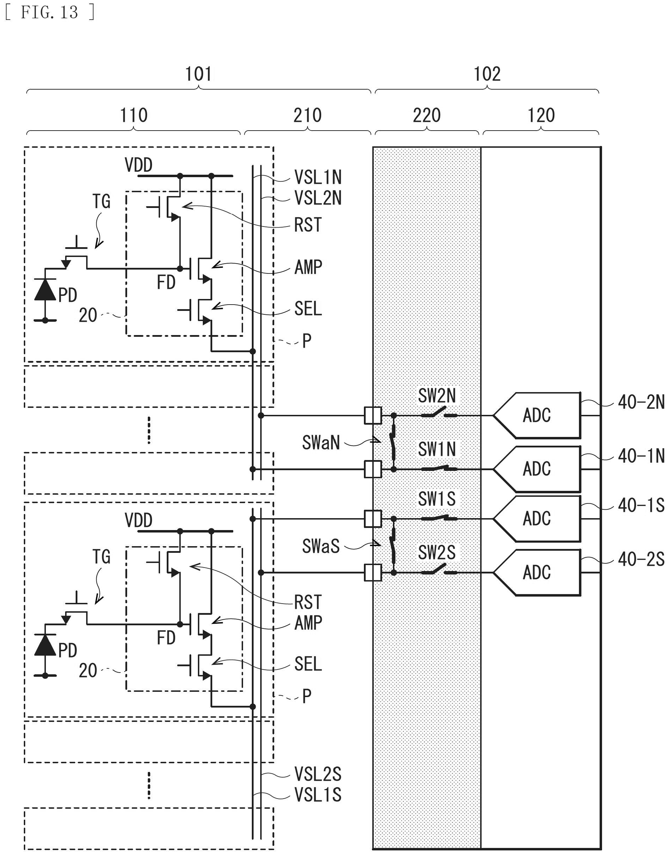

FIG. 13 is a configuration diagram schematically illustrating a configuration example 6 of the imaging device 1 according to the embodiment.

The imaging device 1 according to the configuration example 6 has a configuration in which, unlike the forgoing configuration example 4, the first switching switch SW1N, the third switching switch SW2N, the first adder switch SWaN, the second switching switch SW1S, the fourth switching switch SW2S, and the second adder switch SWaS are all provided in the second wiring layer 220.

Other configurations may be substantially similar to those of the forgoing configuration example 4.

### <Modification Examples>

In each configuration example described above, the first substrate 101 may have a configuration including two substrates. For example, the photodiode PD, the transfer transistor TG, and the floating diffusion FD in each pixel P may be formed on one of the two substrates, and the other components of the readout circuit 20 may be formed on the other of the two substrates.

### <1.3 Effects>

As described above, according to the imaging device 1 as the detection device according to the embodiment, at least one transistor is provided between the readout circuit 20 in the first substrate 101 and the signal processor 112 in the second substrate 102. The transistor is provided in at least any one of the first wiring layer 210 of the first substrate 101 and the second wiring layer 220 of the second substrate 102. Thus, it is possible to reduce redundancy of wirings, leading to downsizing and speeding up of signal readout.

According to the imaging device 1 as the detection device according to the embodiment, a configuration is provided in which a switching transistor may be provided in at least any one of the first wiring layer 210 and the second wiring layer 220. This makes it possible to synthesize signals outputted from different signal lines without providing a synthetic circuit on the circuit substrate (second substrate 102). This leads to downsizing of the circuit substrate and a higher degree of freedom of floor planning. Moreover, the reduction of the redundancy of the wirings leads to reduction of a wiring load and speeding up of signal processing. As a result, it is also possible to obtain effects of reducing power consumption.

It is to be noted that the effects described herein are merely illustrative and nonlimiting. There may be other effects. This also applies to the effects of other embodiments in the following.

### <2. Applied Example to Mobile Body>

The technology according to the present disclosure (the present technology) is applicable to various products. For example, the technology according to the present disclosure may be embodied in the form of an apparatus to be mounted on a mobile body of any kind. Examples of the mobile body include an automobile, an electric vehicle, a hybrid electric vehicle, a motorcycle, a bicycle, a personal mobility device, an airplane, a drone, a vessel, and a robot.

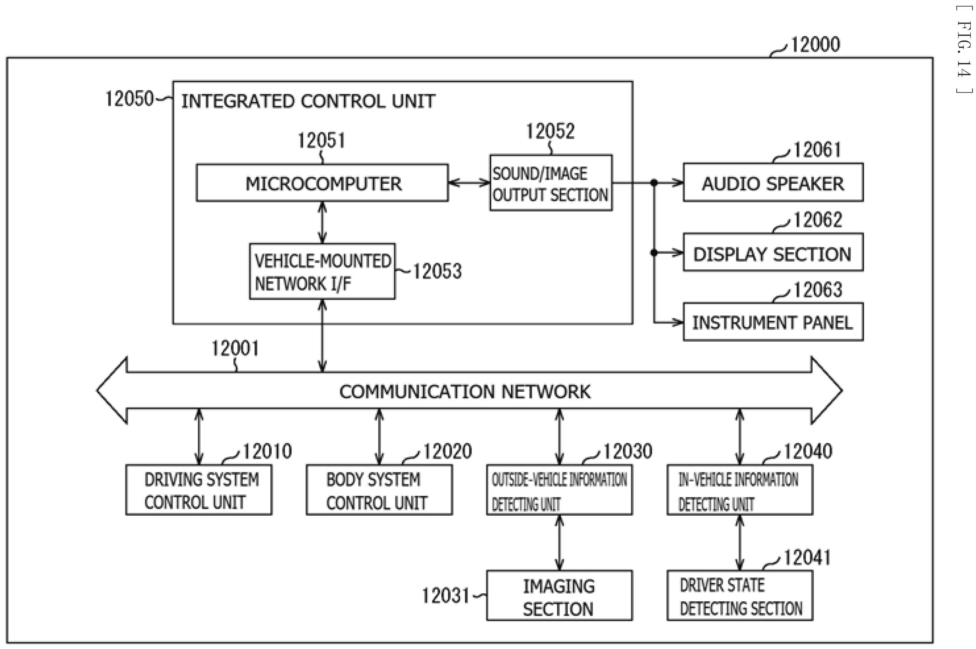

FIG. 14 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 14, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 14, an audio speaker 12061, a display section 12062, and an instrument panel 12063 are illustrated as the output device. The display section 12062 may, for example, include at least one of an on-board display and a head-up display.

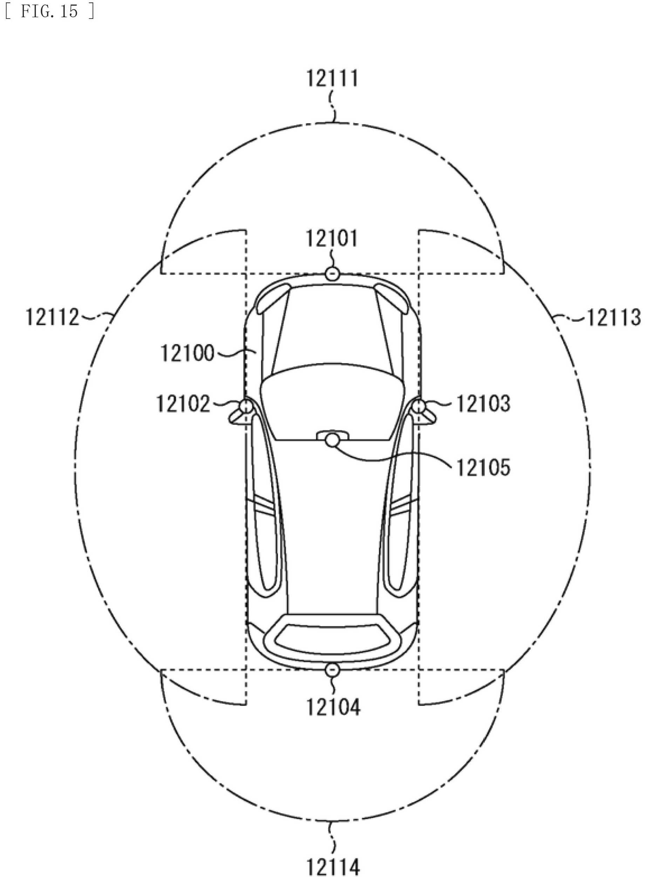

FIG. 15 is a diagram depicting an example of the installation position of the imaging section 12031.

In FIG. 15, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 15 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

In the forgoing, described is an example of the vehicle control system to which the technology according to the present disclosure is applicable. The technology according to the present disclosure is applicable to the imaging section 12031, the driver state detecting section 12041, and the imaging sections 12101, 12102, 12103, 12104, and 12105, in the configurations described in the forgoing.

### <3. Other Embodiments>

The present technology according to the present disclosure is by no means limited to the description of the forgoing embodiment, and various modifications may be made.

For example, the present technology may have the following configuration.

According to the present technology having the following configuration, the at least one transistor is provided between the readout circuit in the first substrate and the signal processor in the second substrate. The transistor is provided in at least any one of the first wiring layer of the first substrate and the second wiring layer of the second substrate. Thus, it is possible to provide the light detecting device that makes it possible to reduce redundancy of wirings, leading to downsizing and speeding up of signal readout.
<1> A light detecting device including:
   a first substrate including a photoelectric conversion element and a readout circuit, the photoelectric conversion element photoelectrically converting light, and the readout circuit being configured to output a signal based on electric charge photoelectrically converted in the photoelectric conversion element;
   a second substrate stacked with the first substrate and including a signal processor, the signal processor being configured to perform signal processing on the signal outputted from the readout circuit; and
   at least one transistor provided between the readout circuit and the signal processor,
   the first substrate including a first semiconductor layer and a first wiring layer,
   the second substrate including a second semiconductor layer and a second wiring layer, and
   the transistor being provided in at least any one of the first wiring layer and the second wiring layer.
<2> The light detecting device according to the forgoing <1>, in which
   the transistor includes a switching transistor configured to switch an electrical coupling state between the readout circuit and the signal processor.
<3> The light detecting device according to the forgoing <1> or <2>, in which
   the first substrate includes a plurality of pixels each including the photoelectric conversion element and the readout circuit,
   the first substrate further includes a signal line to which the signal from the readout circuit in each of the plurality of the pixels is outputted, and
   the transistor includes a switching transistor configured to switch an electrical coupling state between the signal line and the signal processor.
<4> The light detecting device according to the forgoing <3>, in which
   the signal line includes
      a first divided signal line to which the signal from the readout circuit in at least one first pixel out of the plurality of the pixels is outputted, and
      a second divided signal line to which the signal from the readout circuit in at least one second pixel out of the plurality of the pixels is outputted, and
   the switching transistor includes
      a first switching transistor including a first coupling end and a second coupling end, the first coupling end being coupled to the first divided signal line, the second coupling end being coupled to the signal processor, and the first switching transistor being configured to switch an electrical coupling state between the first divided coupling state and the signal processor, and
      a second switching transistor including a first coupling end and a second coupling end, the first coupling end being coupled to the second divided signal line, the second coupling end being coupled to the signal processor, and the second switching transistor being configured to switch an electrical coupling state between the second divided signal line and the signal processor.
<5> The light detecting device according to the forgoing <4>, further including a coupling unit provided in any one of the first wiring layer and the second wiring layer and coupled to the second end of the first switching transistor and the second end of the second switching transistor, in which
   the second end of the first switching transistor and the second end of the second switching transistor are commonly coupled to the signal processor through the coupling unit.
<6> The light detecting device according to the forgoing <4>, in which
   the signal line further includes
      a third divided signal line to which the signal from the readout circuit in the at least one first pixel out of the plurality of the pixels, and
      a fourth divided signal line to which the signal from the readout circuit in the at least one second pixel out of the plurality of the pixels, and
   the switching transistor further includes
      a third switching transistor including a first coupling end and a second coupling end, the first coupling end being coupled to the third divided signal line, the second coupling end being coupled to the signal processor, the third switching transistor being configured to switch an electrical coupling state between the third divided signal line and the signal processor, and
      a fourth switching transistor including a first coupling end and a second coupling end, the first coupling end being coupled to the fourth divided signal line, the second coupling end being coupled to the signal processor, the fourth switching transistor being configured to switch an electrical coupling state between the fourth divided signal line and the signal processor.
<7> The light detecting device according to the forgoing <6>, further including:
   a first adder transistor configured to switch an electrical coupling state between the first divided signal line and the third divided signal line, and configured to add up a plurality of the signals from a plurality of the readout circuits in a plurality of the first pixels; and
   a second adder transistor configured to switch an electrical coupling state between the second divided signal line and the fourth divided signal line, and configured to add up a plurality of the signals from a plurality of the readout circuits in a plurality of the second pixels.
<8> The light detecting device according to the forgoing <6> or <7>, further including:
   a first coupling unit provided in any one of the first wiring layer and the second wiring layer, and coupled to the second coupling end of the first switching transistor and the second coupling end of the second coupling end of the second switching transistor; and
   a second coupling unit provided in any one of the first wiring layer and the second wiring layer, and coupled to the second coupling end of the third switching transistor and the second coupling end of the fourth switching transistor, in which
   the second coupling end of the first switching transistor and the second coupling end of the second switching transistor are commonly coupled to the signal processor through the first coupling unit, and
   the second coupling end of the third switching transistor and the second coupling end of the fourth switching transistor are commonly coupled to the signal processor through the second coupling unit.
<9> The light detecting device according to any one of the forgoing <1> to <8>, in which
   the signal processor includes at least one AD conversion circuit configured to convert the signal outputted from the readout circuit into a digital signal.

This application claims the benefit of Japanese Priority Patent Application No. 2023-212393 filed with the Japan Patent Office on December 15, 2023, the entire contents of which are incorporated herein by reference.

It should be understood by those skilled in the art that various modifications, combinations, sub-combinations and alterations may occur depending on design requirements and other factors insofar as they are within the scope of the appended claims or the equivalents thereof.

## Claims

1. A light detecting device comprising:
a first substrate including a photoelectric conversion element and a readout circuit, the photoelectric conversion element photoelectrically converting light, and the readout circuit being configured to output a signal based on electric charge photoelectrically converted in the photoelectric conversion element;
a second substrate stacked with the first substrate and including a signal processor, the signal processor being configured to perform signal processing on the signal outputted from the readout circuit; and
at least one transistor provided between the readout circuit and the signal processor,
the first substrate including a first semiconductor layer and a first wiring layer,
the second substrate including a second semiconductor layer and a second wiring layer, and
the transistor being provided in at least any one of the first wiring layer and the second wiring layer.

2. The light detecting device according to claim 1, wherein
the transistor comprises a switching transistor configured to switch an electrical coupling state between the readout circuit and the signal processor.

3. The light detecting device according to claim 1, wherein
the first substrate includes a plurality of pixels each including the photoelectric conversion element and the readout circuit,
the first substrate further includes a signal line to which the signal from the readout circuit in each of the plurality of the pixels is outputted, and
the transistor comprises a switching transistor configured to switch an electrical coupling state between the signal line and the signal processor.

4. The light detecting device according to claim 3, wherein
the signal line includes
a first divided signal line to which the signal from the readout circuit in at least one first pixel out of the plurality of the pixels is outputted, and
a second divided signal line to which the signal from the readout circuit in at least one second pixel out of the plurality of the pixels is outputted, and
the switching transistor includes
a first switching transistor including a first coupling end and a second coupling end, the first coupling end being coupled to the first divided signal line, the second coupling end being coupled to the signal processor, and the first switching transistor being configured to switch an electrical coupling state between the first divided coupling state and the signal processor, and
a second switching transistor including a first coupling end and a second coupling end, the first coupling end being coupled to the second divided signal line, the second coupling end being coupled to the signal processor, and the second switching transistor being configured to switch an electrical coupling state between the second divided signal line and the signal processor.

5. The light detecting device according to claim 4, further comprising a coupling unit provided in any one of the first wiring layer and the second wiring layer and coupled to the second end of the first switching transistor and the second end of the second switching transistor, wherein
the second end of the first switching transistor and the second end of the second switching transistor are commonly coupled to the signal processor through the coupling unit.

6. The light detecting device according to claim 4, wherein
the signal line further includes
a third divided signal line to which the signal from the readout circuit in the at least one first pixel out of the plurality of the pixels, and
a fourth divided signal line to which the signal from the readout circuit in the at least one second pixel out of the plurality of the pixels, and
the switching transistor further includes
a third switching transistor including a first coupling end and a second coupling end, the first coupling end being coupled to the third divided signal line, the second coupling end being coupled to the signal processor, the third switching transistor being configured to switch an electrical coupling state between the third divided signal line and the signal processor, and
a fourth switching transistor including a first coupling end and a second coupling end, the first coupling end being coupled to the fourth divided signal line, the second coupling end being coupled to the signal processor, the fourth switching transistor being configured to switch an electrical coupling state between the fourth divided signal line and the signal processor.

7. The light detecting device according to claim 6, further comprising:
a first adder transistor configured to switch an electrical coupling state between the first divided signal line and the third divided signal line, and configured to add up a plurality of the signals from a plurality of the readout circuits in a plurality of the first pixels; and
a second adder transistor configured to switch an electrical coupling state between the second divided signal line and the fourth divided signal line, and configured to add up a plurality of the signals from a plurality of the readout circuits in a plurality of the second pixels.

8. The light detecting device according to claim 6, further comprising:
a first coupling unit provided in any one of the first wiring layer and the second wiring layer, and coupled to the second coupling end of the first switching transistor and the second coupling end of the second coupling end of the second switching transistor; and
a second coupling unit provided in any one of the first wiring layer and the second wiring layer, and coupled to the second coupling end of the third switching transistor and the second coupling end of the fourth switching transistor, wherein
the second coupling end of the first switching transistor and the second coupling end of the second switching transistor are commonly coupled to the signal processor through the first coupling unit, and
the second coupling end of the third switching transistor and the second coupling end of the fourth switching transistor are commonly coupled to the signal processor through the second coupling unit.

9. The light detecting device according to claim 1, wherein
the signal processor includes at least one AD conversion circuit configured to convert the signal outputted from the readout circuit into a digital signal.
